Europäisches Patentamt

European Patent Office

Office européen des brevets

(19)

(11) **EP 0 834 992 B1**

(12) **EUROPÄISCHE PATENTSCHRIFT**

(45) Veröffentlichungstag und Bekanntmachung des Hinweises auf die Patenterteilung:
**20.01.1999 Patentblatt 1999/03**

(51) Int Cl.6: **H03K 3/00**, H03H 19/00

(21) Anmeldenummer: **96115764.1**

(22) Anmeldetag: **02.10.1996**

(54) **Monolithische MOS Switched-Capacitor-Schaltung mit on-chip Oszillator**

Monolithic MOS switched-capacitor circuit with on-chip oscillator

Circuit MOS monolithique à capacités commutées avec oscillateur intégré

(84) Benannte Vertragsstaaten:
**AT CH DE DK ES FR GB IT LI NL**

(43) Veröffentlichungstag der Anmeldung:
**08.04.1998 Patentblatt 1998/15**

(73) Patentinhaber:
- **ENVEC Mess- und Regeltechnik GmbH + Co.
  79576 Weil am Rhein (DE)**
- **Endress + Hauser GmbH + Co.
  79689 Maulburg (DE)**
- **VEGA Grieshaber KG
  77709 Wolfach (DE)**
- **KAVLICO CORPORATION
  Moorpark, CA 93021 (US)**

(72) Erfinder: **Seesink, Petrus H.
5685 AG Best (NL)**

(74) Vertreter: **Morstadt, Volker, Dipl.-Ing.
Endress + Hauser
Zentrale Patentabteilung
Postfach 2222
79574 Weil am Rhein (DE)**

(56) Entgegenhaltungen:
- ELECTRONIC DESIGN, Bd. 37, Nr. 8, 13.April 1989, Seiten 77-80, 86, 90, 92, XP000099000 GOODENOUGH F: "FOR FILTERING: IT'S SWITCHED-CAPACITOR ICS"
- EUROCON 86; 21-23 /4/1986; PARIS (FR); BLOCS DE BASE ANALOGIQUES POUR DES SYSTEMES DE COMMUNICATION. (MARIANO ACEVES et al); P659-664. XP002027103
- IEEE TRANSACTIONS ON CIRCUITS AND SYSTEMS, Bd. 31, Nr. 4, April 1984, NEW YORK US, Seiten 354-368, XP002027102 B. J. HOSTICKA ET AL: "DESIGN OF NONLINEAR ANALOG SWITCHED CAPACITOR CIRCUITS USING BUILDING BLOCKS"

**Beschreibung**

Die Erfindung betrifft eine monolithisch mittels Enhancement-Isolierschicht-Feldeffekt-Transistoren integrierte Switched-Capacitor-Schaltung, im folgenden kurz MOS-SC-Schaltung genannt, die also auf und in einem Halbleiter-Chip realisiert ist.

Wesentliche Bestandteile von solchen MOS-SC-Schaltungen sind:

- Operationsverstärker, deren jeweiliger Ruhestrom von einem Widerstand oder von einer Konstanstromquelle bestimmt ist, die Teil eines Stromspiegels sein kann,
- ein On-Chip-Taktoszillator zur Abgabe eines Taktsignals, der ein RC-Taktoszillator ist, dessen Frequenz von einem Oszillator-Widerstand und einem Oszillator-Kondensator bestimmt ist,
- zwischen einem Signaleingang und einem Signalausgang liegende Kondensatoren und
- Schalter in der Form von Transistoren, über die die jeweiligen Kondensatoren im Betrieb von den jeweiligen Operationsverstärkern, getaktet vom Taktsignal, aufgeladen oder entladen werden.

Bei MOS-SC-Schaltungen mit den beiden erwähnten Arten von Taktoszillatoren sind deren Frequenz und/oder deren Frequenzkonstanz nicht so kritisch. Solche MOS-SC-Schaltungen sind z.B. SC-Analog/Digital-Wandler oder SC-Digital/Analog-Wandler oder die in der EP-A 711 976 beschriebene Schaltung.

Bei der monolithischen Realisierung derartiger MOS-SC-Schaltungen, also beim Entwurf des konkreten Layouts der einzelnen Halbleiterschichten und der dafür erforderlichen Belichtungs- und Diffusionsmasken, dem sogenannten Design, und bei der Wahl der konkreten halbleiter-technischen Verfahrenschritte, treten u.a. folgende Teilprobleme auf:

a) Die Einschwingzeit von Operationsverstärkern muß einerseits so kurz sein, daß der von der Einschwingzeit bedingte Fehler ausreichend klein ist, z.b. 0,1 % beträgt, andererseits darf die Einschwingzeit nicht so kurz sein, daß der Leistungsbedarf größer als nötig ist und sich die Rauschempfindlichkeit wegen der Vergrößerung der Rauschbandbreite erhöht.

b) Die konkrete Einschwingzeit eines gefertigten Operationsverstärkers wird vom tatsächlich realisierten Wert des seinen Ruhestrom festlegenden Widerstands oder vom tatsächlich realisierten Wert des Stromes der Konstantstromquelle bestimmt; hierfür liegt jeweils die Herstelltoleranz im Bereich von 20%.

c) Die konkrete Transkonduktanz der einzelnen Transistoren ist im wesentlichen von Toleranzen der Dotierung der einzelnen Halbleiterzonen, von Toleranzen der Dicke von nicht im Gatebereich erzeugten bzw. aufgebrachten, also vorhandenen, Siliciumdioxid-Schichten, also dem sogenannten Feldoxid, von Toleranzen der Gate-Schwellenspannung und von Toleranzen der Kanal länge abhängig; hierfür liegt die Herstelltoleranz im Bereich von 50%.

d) Der konkrete Wert der Toleranz der Kapazität der Kondensatoren beträgt üblicherweise 20%.

e) Der Widerstand im stromleitenden Zustand der die Schalter realisierenden Transistoren, also deren sogenannter jeweiliger ON-Widerstand, muß einerseits so klein sein, daß die von ihm und dem zugehörigen Kondensator gebildete Zeitkonstante klein genug ist, und darf andererseits nicht so klein sein, daß es zu einem Übersprechen des Taktsignals und zu größeren Leckeffekten als nötig kommt.

f) Die Zeitkonstanten der einzelnen Schalter-Kondensator-Glieder bestimmen zusammen mit der Einschwingzeit der jeweiligen Operationsverstärker und ferner zusammen mit der Betriebstemperatur und dem konkreten Wert der Betriebsspannung die Gesamt-Einschwingzeit. Dabei müssen die jeweiligen Schalter-Kondensator-Operationsverstärker-Einheiten innerhalb einer Zeitdauer eingeschwungen sein, die durch die vom Taktoszillator erzeugten Impulse bestimmt ist. Hierbei sind alle erwähnten Toleranzen wirksam bzw. zu berücksichtigen, die nach den obigen Ausführungen im Bereich von 50% liegen. Die Toleranz der Frequenz eines On-Chip-RC-Taktoszillators liegt dabei im Bereich von 20% bis 30%.

g) Da die erwähnten Toleranzen der SC-Schaltung und die zuletzt genannte Toleranz des Taktoszillators i.a. nicht miteinander korreliert sind und somit sich addieren, ergibt sich für das erwähnte Design unter dem Worst-Case-Gesichtspunkt ein zu großer zu berücksichtigender Toleranzbereich. Dieser Sachverhalt läßt sich durch die Differenz zwischen der Periodendauer des Taktsignals und dem benötigten typischen Wert der Einschwingzeit der Operationsverstärker veranschaulichen, welche Differenz hier als Margin M bezeichnet wird und bei Worst-Case im Bereich von 80% liegt. Selbst wenn die erwähnten Toleranzen der SC-Schaltung und die Toleranz des Taktoszillators miteinander korreliert sind, läßt sich allenfalls ein Margin von 30% erreichen.

Die Erfindung dient der Lösung dieser Probleme im Hinblick auf eine wesentliche Verkleinerung des beim Design zu berücksichtigenden Toleranzbereichs bzw.

Margins.

Die Erfindung besteht hierzu in einer monolithisch mittels Enhancement-Isolierschicht-Feldeffekt-Transistoren integrierten Switched-Capacitor-Schaltung

- mit mindestens einem Operationsverstärker,

-- der einen seinen Ruhestrom bestimmenden, als dauernd stromleitend betriebenen Transistor realisierten Widerstand enthält,

- mit einem On-Chip-Taktoszillator zur Abgabe eines Taktsignals,

-- der entweder ein RC-Taktoszillator ist, dessen Frequenz von einem als dauernd stromleitend betriebenen Transistor realisierten Oszillator-Widerstand und einem Oszillator-Kondensator bestimmt ist,

-- oder der ein stromgesteuerter Taktoszillator ist, dessen Frequenz vom Ruhestrom des Operationsverstärkers bestimmt ist,

- mit mindestens einem Kondensator und
- mit mindestens einem Schalter in der Form eines Transistors, über den der Kondensator im Betrieb vom Operationsverstärker, getaktet vom Taktsignal, aufgeladen oder entladen wird.

Nach einer Ausgestaltung der Erfindung ist der dauernd stromleitende Transistor ein entsprechend beschaltetes CMOS-Transmission-Gate.

Zur Erzielung der oben genannten Problemlösung wird also bei der Erfindung sowohl der den Ruhestrom der Operationsverstärker bestimmende Widerstand als auch der frequenz-mitbestimmende Oszillator-Widerstand jeweils als ON-Widerstand eines dauernd stromleitend betriebenen MOS-Transistors realisiert.

Ein Vorteil der Erfindung besteht darin, daß sich der Toleranzbereich bzw. der Margin gegen 10% bringen läßt, da die Geschwindigkeit der SC-Schaltung mit der Periodendauer des Taktsignals verrastet ist.

Somit ergibt sich als ein weiterer Vorteil ein kleinerer Rauschpegel, da aufgrund der schmaleren Bandbreite der Operationsverstärker das durch Aliasing bedingte Rauschspektrum in geringerem Maße in Frequenzbereichen oberhalb der Frequenz des Taktsignals erscheint. Ferner sind der erwähnte Leistungsbedarf verringert und das erläuterte Übersprechen des Taktsignals weitestgehend vermieden.

Die Erfindung und weitere Eigenschaften werden nun anhand der Figuren der Zeichnung näher erläutert, in denen gleiche bzw. einander entsprechende Teile mit denselben Bezugszeichen versehen sind.

Fig. 1      zeigt ein Schaltbild einer einfachen SC-Schaltung mit Realisierung von leitenden und nichleitenden Schaltstrecken mittels CMOS-Transmission-Gates,

Fig. 2      zeigt ein Prinzipschaltbild eines RC-Oszillators,

Fig. 3      zeigt ein Schaltbild eines RC-Taktoszillators nach der Erfindung,

Fig. 4      zeigt ein Prinzipschaltbild eines in CMOS-Technik realisierten stromgesteuerten Taktoszillators,

Fig. 5      zeigt ein Prinzipschaltbild eines einfachen mit P-Kanal-Transistoren realisierten Differenzverstärkers,

Fig. 6      zeigt Schaltbilder verschiedener einfacher Ruhestrom-Einstell-Schaltungen von MOS- bzw. CMOS-Operationsverstärkern,

Fig. 7      zeigt Schaltbilder verschiedener erfindungsgemäßer Ruhestrom-Einstell-Schaltungen von MOS- bzw. CMOS-Operationsverstärkern, und

Fig. 8 bis 11      zeigen verschiedene Margin-Diagramme.

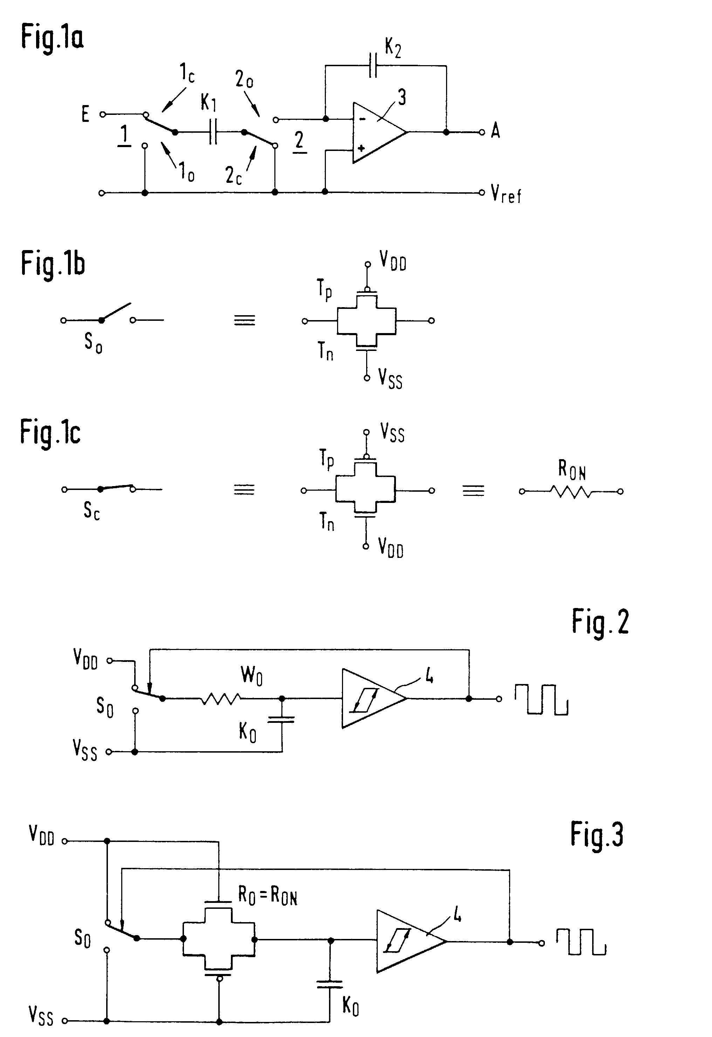

Fig. 1a zeigt ein Schaltbild einer einfachen SC-Schaltung, die auch als Grundschaltung umfangreicher SC-Schaltungen aufgefaßt werden kann, auf der letztere aufbauen. Ein Eingang E läßt sich einerseits über eine erste Schaltstrecke $1_c$ eines ersten Umschalters 1 mit einem ersten Anschluß eines ersten Kondensator $K_1$ bzw. andererseits über eine zweite Schaltstrecke $1_o$ mit einem Referenz-Potential $V_{ref}$ verbinden, das z.B. das Potential eines Schaltungsnullpunkts sein kann.

Ein zweiter Anschluß des ersten Kondensators $K_1$ läßt sich einerseits über eine erste Schaltstrecke $2_o$ eines zweiten Umschalters 2 mit einem invertierenden Eingang eines Operationsverstärkers 3 bzw. andererseits über eine zweite Schaltstrecke $2_c$ mit dem Referenz-Potential $V_{ref}$ verbinden. Ein nicht-invertierender Eingang des Operationsverstärkers 3 liegt am Referenz-Potential $V_{ref}$. Ein Ausgang A des Operationsverstärkers 3 ist über einen zweiten Kondensator $K_2$ an dessen invertierendem Eingang angeschlossen und läßt sich somit auch mit dem zweiten Anschluß des ersten Kondensators $K_1$ verbinden.

In der in Fig. 1a gezeigten Schaltstellung der beiden Umschalter 1, 2 wird der erste Kondensator $K_1$ von einem am Eingang E liegenden Signal aufgeladen. Wenn die beiden Umschalter 1, 2 in ihre anderen Schaltstellungen gebracht werden, wird die Aufladung unterbrochen bzw. beendet und die auf den ersten Kondensator $K_1$ gelangte Ladung wird zum zweiten Kondensator $K_2$

weitergeleitet.

Als Beispiel für eine bevorzugte Realisierung von leitenden und nichleitenden Schaltstrecken von Umschaltern von SC-Schaltungen können CMOS-Transmission-Gates dienen, die bekanntlich Teilschaltungen von integrierten CMOS-Schaltungen sind, also von integrierten Schaltungen mit komplementären Enhancement-Isolierschicht-Feldeffekt-Transistoren. Zur Realisierung der Schaltstrecken können aber auch Feldeffekt-Transistoren eines einheitlichen Leitungstyps verwendet werden.

In Fig. 1b bzw. 1c ist die Realisierung einer offenen bzw. geschlossenen Schaltstrecke $S_o$ bzw. $S_c$ mittels eines CMOS-Transmission-Gates gezeigt. Es besteht aus der Parallelschaltung der gesteuerten Strompfade eines P-Kanal-Transistors $T_p$ und eines N-Kanal-Transistors $T_n$.

Damit entsprechend Fig. 1b beide Transistoren gesperrt und somit beide Strompfade nichtleitend sind, liegt bekanntlich am Gate des P-Kanal-Transistors $T_p$ eine Spannung $V_{DD}$ und zugleich am Gate des N-Kanal-Transistors $T_n$ eine Spannung $V_{SS}$. Die Spannung $V_{DD}$ ist wesentlich negativer als die Gate-Schwellspannung des P-Kanal-Transistors $T_p$, und die Spannung $V_{SS}$ ist wesentlich positiver als die Gate-Schwellspannung des N-Kanal-Transistors $T_n$.

Damit entsprechend Fig. 1c beide Strompfade der beiden Transistoren leitend sind, liegt nun am Gate des P-Kanal-Transistors $T_p$ die Spannung $V_{SS}$ und zugleich am Gate des N-Kanal-Transistors $T_n$ die Spannung $V_{DD}$. Nun ist die Spannung $V_{DD}$ wesentlich positiver als die Gate-Schwellspannung des P-Kanal-Transistors $T_p$, und die Spannung $V_{SS}$ ist wesentlich negativer als die Gate-Schwellspannung des P-Kanal-Transistors $T_n$. Die beiden leitenden komplementären Transistoren realisieren somit einen Widerstand $R_{ON}$, der üblicherweise einen Wert in der Größenordnung von 10 kΩ haben kann.

In Fig. 2 ist das Prinzipschaltbild eines RC-Oszillators dargestellt. Über einen Oszillator-Widerstand $W_O$ schaltet ein Oszillator-Umschalter $S_O$ einen Oszillator-Kondensator $K_O$ zwischen den Spannungen $V_{DD}$ und $V_{SS}$ hin und her. Damit dies selbstschwingend abläuft, liegt der Verbindungspunkt von Oszillator-Widerstand $W_O$ und Oszillator-Kondensator $K_O$ an einem Eingang eines Schmitt-Triggers 4, von dem ein Ausgang mit dem Steuereingang des Oszillator-Umschalters $S_O$ verbunden ist. An diesem Ausgang entsteht somit ein Rechtecksignal, dessen Frequenz im wesentlichen von der Zeitkonstante des von Widerstand $W_O$ und Kondensator $K_O$ gebildeten RC-Glieds bestimmt ist. Diese ist bekanntlich gleich dem Produkt aus dem Wert R des Widerstands $W_O$ und dem Wert C des Kondensators $K_O$.

In Fig. 3 ist ein mit dem Schaltbild der Fig. 2 weitgehend übereinstimmendes Schaltbild eines RC-Taktoszillators entsprechend einem Teilaspekt der Erfindung gezeigt. Der Unterschied zu Fig. 2 besteht darin, daß der Widerstand $W_O$ durch ein dauernd leitendes CMOS-Transmission-Gate entsprechend Fig. 1c realisiert ist, so daß für den Wert R des Widerstands $W_O$ gilt: $R = R_{ON}$.

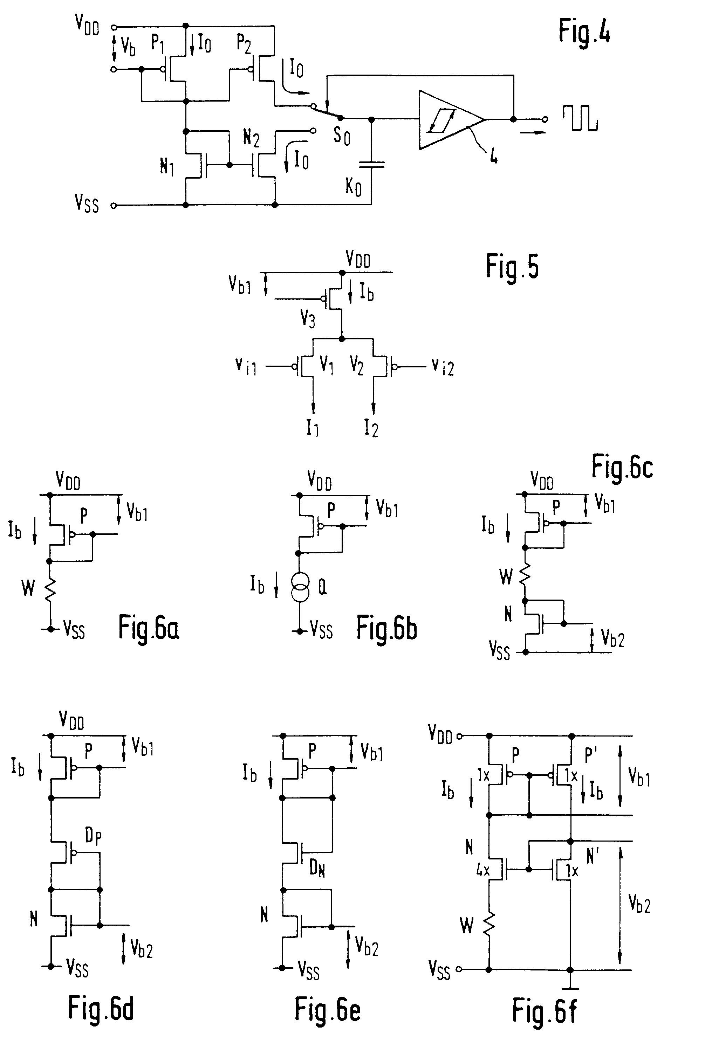

Die Fig. 4 zeigt ein Prinzipschaltbild eines üblichen in CMOS-Technik realisierten stromgesteuerten Taktoszillators. Hierbei ist der Widerstand $W_O$ nach den Fig. 2 und 3 durch einen CMOS-Stromspiegel ersetzt. Dieser besteht aus einer Serienschaltung eines P-Kanal-Transistor $P_1$ und eines N-Kanal-Transistor $N_1$ sowie aus einem weiteren P-Kanal-Transistor $P_2$ und aus einem weiteren N-Kanal-Transistor $N_2$.

In der Serienschaltung sind die gesteuerten Strompfade des P-Kanal-Transistors $P_1$ und des N-Kanal-Transistors $N_1$ so in Reihe geschaltet, daß der Drain-Anschluß des P-Kanal-Transistors $P_1$ an der Spannung $V_{DD}$ und der Source-Anschluß des N-Kanal-Transistors $N_1$ an der Spannung $V_{SS}$ liegen.

Der Drain-Anschluß des P-Kanal-Transistors $P_2$ liegt ebenfalls an der Spannung $V_{DD}$ und der Source-Anschluß des N-Kanal-Transistors $N_2$ ebenfalls an der Spannung $V_{SS}$. Die Gate-Anschlüsse der beiden N-Kanal-Transistoren $N_1$, $N_2$ sind miteinander verbunden und liegen ferner am Verbindungspunkt der beiden Transistoren der Serienschaltung, also am Drain-Anschluß des N-Kanal-Transistors $N_1$ und am Source-Anschluß des P-Kanal-Transistors $P_1$. An diesem Verbindungspunkt liegt auch der jeweilige Gate-Anschluß der beiden P-Kanal-Transistoren $P_1$, $P_2$.

Der Source-Anschluß des weiteren P-Kanal-Transistors $P_2$ liegt an einem ersten Eingang des Umschalters $S_O$ und der Drain-Anschluß des weiteren N-Kanal-Transistors $N_2$ an einem zweiten Eingang des Umschalter $S_O$. Dessen Ausgang ist wie in Fig. 3 mit dem Eingang des Schmitt-Triggers 4 und mit dem Kondensator $K_O$ verbunden.

Zwischen der Spannung $V_{DD}$ und dem Gate-Anschluß des P-Kanal-Transistors $P_1$ liegt eine Vorspannung $V_b$, die den in diesem Transistor fließenden Ruhestrom $I_O$ mitbestimmt. Mittels der Vorspannung $V_b$ kann somit der Ruhestrom $I_O$ vom Benutzer eingestellt werden.

Aufgrund der bekannten Eigenschaften eines Stromspiegels fließt somit dieser Ruhestrom $I_O$ auch im weiteren P-Kanal-Transistors $P_2$, wenn, wie es in Fig. 4 gezeichnet ist, der Umschalter $S_O$ in der gezeichneten Stellung steht, und lädt somit den Kondensator $K_O$ auf.

Schaltet der Schmitt-Trigger 4 den Umschalter $S_O$ in seine andere Schaltstellung, so wird der Kondensator $K_O$ vom Ruhestrom $I_O$ wieder entladen. Nunmehr fließt dieser Ruhestrom $I_O$ nämlich durch den weiteren N-Kanal-Transistors $N_2$, weil auch im N-Kanal-Transistors $N_1$ dieser Ruhestrom fließt und die Stromspiegel-Eigenschaft dies bedingt.

In Fig. 5 ist ein Prinzipschaltbild eines einfachen mit P-Kanal-Transistoren realisierten Differenzverstärkers als Grundglied von Operationsverstärkern gezeigt. Der Differenzverstärker umfaßt zwei Verstärker-Transistoren $V_1$, $V_2$, deren Source-Anschlüsse miteinander verbunden sind und über den gesteuerten Ruhestrompfad eines Konstantstrom-Transistors $V_3$ mit der Spannung $V_{DD}$ gekoppelt sind. Zwischen dessen Gate-Anschluß und der Spannung $V_{DD}$ liegt eine Vorspannung $V_{b1}$, die den in diesem Transistor fließenden Ruhestrom $I_b$ mitbestimmt. Mittels der Vorspannung $V_{b1}$ kann somit auch hier vom Benutzer der Ruhestrom $I_b$ eingestellt werden.

Im Verstärker-Transistor $V_1$ und im Verstärker-Transistor $V_2$ fließt eine Ruhestrom $I_1$ bzw. $I_2$, wobei, wie für Differenzverstärker charakteristisch, die Summe dieser beiden Ströme konstant und gleich dem Ruhestrom $I_b$ ist:

$$I_1 + I_2 = I_b = \text{konstant}$$

In Abhängigkeit von einer Differenz eines am jeweiligen Gate-Anschluß der Verstärker-Transistoren $V_1$, $V_2$ liegenden veränderlichen Signals $v_{i1}$ bzw. $v_{i2}$ erfolgt eine Aufteilung des Ruhestrom $I_b$ auf die beiden Verstärker-Transistoren $V_1$, $V_2$, so daß in ihnen veränderliche Ströme $i_1$, $i_2$ fließen. Diese Ströme $i_1$, $i_2$ werden in weiteren Stufen der Operationsverstärker oder in anderen Stufen einer integrierten Schaltung weiterverarbeitet.

Für die Transkonduktanz $g_m$ eines solchen Differenzverstärkers gilt:

$$g_m = \delta(i_1 - i_2)/\delta(v_{i1} - v_{i2}) \approx \sqrt{2\beta_P I_b w/l}.$$

Darin ist $\beta_P$ eine herstellungsbedingte Konstante.

Trotz verschiedener Realisierungsmöglichkeiten von Operationsverstärkern auf der Basis des beschriebenen Differenzverstärker-Grundglieds ist die Transkonduktanz der Operationsverstärker immer eine Funktion der Transkonduktanz des Differenzverstärker-Grundglieds. Daher ist die Bandbreite bzw. die Polfrequenz $f_p$ des Operationsverstärkers eine Funktion des Ruhestroms $I_b$, weil für $f_p$ gilt: $f_p = g_m/(2\pi c)$, wobei mit c die kapazitive Last des Verstärkerausgangs bezeichnet ist.

Bei einem zweistufigen Verstärker ist c die bekannte Miller-Kapazität. Auf jeden Fall muß die kapazitive Last c von derselben Art sein wie die in der SC-Schaltung und im Taktoszillator sonst verwendeten Kondensatoren.

In Fig. 6 sind Schaltbilder verschiedener einfacher Ruhestrom-Einstell-Schaltungen von MOS- bzw. CMOS-Operationsverstärkern gezeigt. Fig. 6a zeigt einen P-Kanal-Transistor P, dessen gesteuerter Strompfad zwischen der Spannung $V_{DD}$ und der Spannung $V_{SS}$ in Serie zu einem Widerstand W geschaltet ist, der den Widerstandswert R hat.

Der Gate-Anschluß des Transistors P liegt an dessen Verbindungspunkt mit dem Widerstand W, und diesem Gate-Anschluß ist eine den in der Serienschaltung aus dem Widerstand W und Transistor P fließenden Ruhestrom $I_b$ mitbestimmende Vorspannung $V_{b1}$ zugeführt. Mitbestimmend deshalb, weil der Ruhestrom $I_b$ ferner von der Dimensionierung der Kanalzone des Transistors W, nämlich vom Quotienten w/l (w ist deren Breite und 1 deren Länge) abhängt. Für den Ruhestrom $I_b$ gilt:

$$I_b \sim (V_{DD} - V_{SS} - V_{b1})/R.$$

In der Schaltung nach Fig. 6b ist der Widerstand W von Fig. 6a durch eine Konstantstromquelle Q ersetzt. In Fig. 6c liegt auf der Seite der Spannung $V_{SS}$ zum Widerstand W der gesteuerte Strompfad eines N-Kanal-Transistors N in Serie. Der Gate-Anschluß des Transistors N liegt an dessen Verbindungspunkt mit dem Widerstand W, und diesem Gate-Anschluß ist eine den in der Serienschaltung aus dem Transistor P dem Widerstand W und dem Transistor N fließenden Ruhestrom $I_b$ zusätzlich mitbestimmende Vorspannung $V_{b2}$ zugefürth. Für den Ruhestrom $I_b$ gilt hier :

$$I_b \sim (V_{DD} - V_{SS} - V_{b1} - V_{b2})/R.$$

In Fig. 6d ist der Widerstand W von Fig. 6c durch einen als Diode geschalteten P-Kanal-Transistor $D_P$ ersetzt, indem dessen gesteuerter Strompfad in die Serienschaltung aus P-Kanal-Transistor P und N-Kanal-Transistor N eingefügt ist. Dabei liegt der Gate-Anschluß des Transistors $D_P$ an dessen Verbindungspunkt mit dem N-Kanaltransistor N, also auch am Gate-Anschluß des letzteren.

In Fig. 6e ist der Widerstand W von Fig. 6c durch einen als Diode geschalteten N-Kanal-Transistor $D_N$ ersetzt, indem dessen gesteuerter Strompfad in die Serienschaltung aus P-Kanal-Transistor P und N-Kanal-Transistor N eingefügt ist. Dabei liegt der Gate-Anschluß des Transistors $D_N$ an dessen Verbindungspunkt mit dem P-Kanaltransistor P, also auch am Gate-Anschluß des letzteren.

Überlicherweise hat der jeweilige als Diode geschaltete Transistor $D_P$ bzw. $D_N$ ein kleines w/l-Verhältnis, um eine Ruhestrom-Einstell-Schaltung mit kleiner Verlustleistung zu erhalten.

In Fig. 6f ist eine Ruhestrom-Einstell-Schaltung mit sehr viel kleinerer Verlustleistung gezeigt. Es sind zwei parallele Schaltungszweige gebildet. In jedem von ihnen fließt der Ruhestrom $I_b$. Ein erster Schaltungszweig, in Fig. 6f ist das der linke, besteht, von der Spannung $V_{DD}$ aus gesehen, aus der Serienschaltung des P-Kanal-Transistors P, des N-Kanal-Transistors N und des Widerstands W. Ein zweiter Schaltungszweig, in Fig. 6f ist das der rechte, besteht, von der Spannung $V_{DD}$ aus gesehen, aus der Serienschaltung eines weiteren P-Kanal-Transistors P' und eines weiteren N-Kanal-Transistors N'.

Der Gate-Anschluß des weiteren P-Kanal-Transistors P' liegt am Gate-Anschluß des P-Kanal-Transistors P. Der Gate-Anschluß Gate-Anschluß des weiteren N-Kanal-Transistors N' liegt am des N-Kanal-Transistors N und ist mit dem Verbindungspunkt der beiden weitern Transistoren verbunden. Die Verbindung zwischen dem Gate-Anschluß des N-Kanal-Transistors N und seinem Drain-Anschluß, wie sie in Fig. 6e vorhanden ist, fehlt.

Der N-Kanal-Transistor hat nun im Vergleich zum jeweiligen w/l-Verhältnis der Transistoren P, P', N' ein vergrößertes w/l-Verhältnis; dies ist durch die Bezeichnung 1x bei den Transistoren P, P', N' und die Bezeichnung 4x bei Transistor N veranschaulicht, wobei 4x angeben soll, daß dessen w/l-Verhältnis viermal größer als das der Transistoren P, P', N' ist.

Der von den Transistoren P, P' gebildete Stromspiegel gewährleistet, daß der Ruhestrom $I_b$ im ersten Schaltungszweig identisch mit dem Ruhestrom $I_b$ im zweiten Schaltungszweig ist. Daher ist die Gate-Source-Spannung $V_{gsN'}$ des Transistors N' kleiner als die Gate-Source-Spannung $V_{gsN}$ des Transistors N. Somit gilt für den Ruhestrom $I_b$:

$$I_b = (V_{gsN'} - V_{gsN})/R .$$

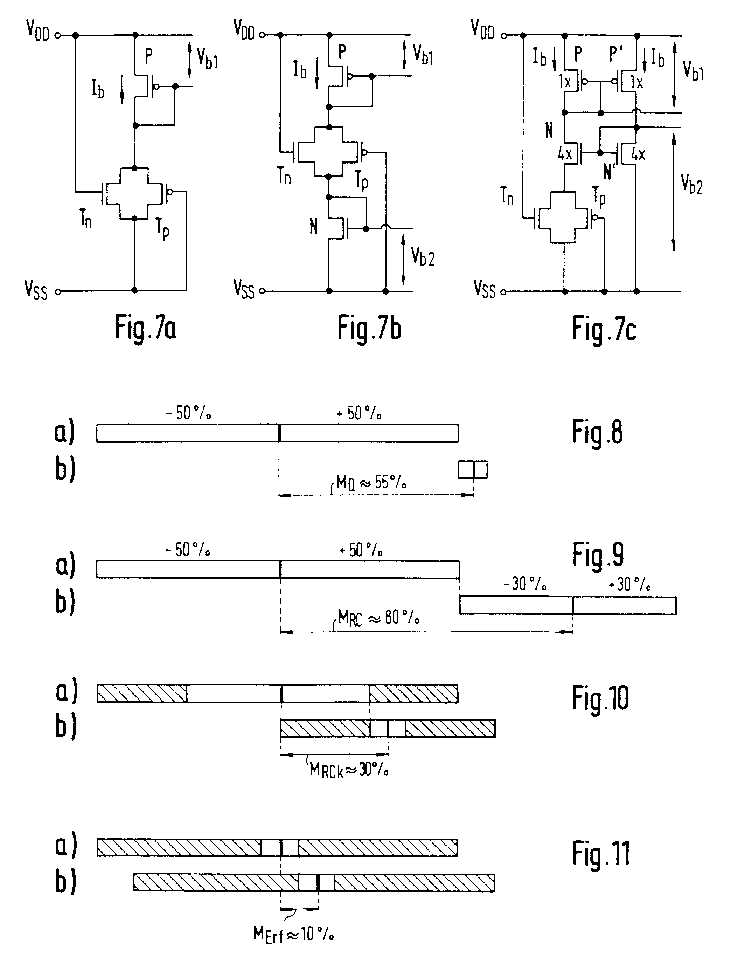

In den Fig. 7a bis 7c sind den Fig. 6a, 6c und 6f vergleichbare Ruhestrom-Einstell-Schaltungen dargestellt, bei denen entsprechend der Erfindung der jeweilige Widerstand W durch ein dauernd leitend gesteuertes CMOS-Transmission-Gate nach Fig. 1c ersetzt ist.

Zur Veranschaulichung der mit der Erfindung erreichbaren Vorteile sind in den jeweiligen beiden Teilfiguren a) bzw. b) der Fig. 8 bis 11 einige Balkendiagramme des Margins dargestellt, letzterer im oben definierten Sinne, vgl. Abschnitt g). Die Teilfiguren a) beziehen sich jeweils auf die erforderliche Einschwingzeit der MOS-SC-Schaltung und die jeweiligen Teilfiguren b) auf die Periodendauer des Taktsignals.

Dabei sind durch die nicht-ausgefüllten Rechtecke die jeweiligen durchschnittlichen Toleranzbereiche, durch die schraffierten Rechtecke miteinander korrelierte Toleranz-Teilbereiche und durch die schmalen ausgefüllten Rechtecke typische Werte dargestellt.

Die Fig. 8a und 8b zeigen, wie bereits oben erwähnt worden ist, den durchschnittlichen Toleranzbereich der benötigten Einschwingzeit eines integrierten MOS-Operationsverstärkers (± 50%) bzw. den Toleranzbereich eines als Taktgenerator dienenden Quarzoszillators. Der daraus sich ergebende Margin $M_Q$ beträgt hier ca. 55%.

Die Fig. 9a und 9b zeigen die Verhältnisse, wie sie bei einem integrierten MOS-Operationsverstärker (Toleranzbereich wieder ± 50%) bzw. einem üblichen On-Chip-RC-Oszillator als Taktgenerator gegeben sind, wenn keine Korrelation zwischen deren Toleranzbereichen vorliegt. Fig. 9a ist mit Fig.8a identisch, und Fig. 9b zeigt den durchschnittlichen Toleranzbereich des On-Chip-RC-Oszillators mit ± 30%. Der Margin $M_{RC}$ beträgt hier ca. 80%.

Die Fig. 10a und 10b zeigen die Verhältnisse, wie sie bei einem üblichen On-Chip-RC-Oszillator als Taktgenerator gegeben sind, wenn eine typische Korrelation zwischen deren Toleranzbereichen vorliegt. Fig. 10a zeigt den durchschnittlichen Toleranzbereich der benötigten Einschwingzeit eines integrierten MOS-Operationsverstärkers von wieder ± 50% mit einem Toleranz-Teilbereich von ±25%.

Daher kann in Fig. 10b der linke Rand des Toleranzbereichs des On-Chip-RC-Oszillators bis zum typischen Wert von Fig. 10a verschoben werden. Da dieser Toleranzbereich einen korrelierten Toleranz-Teilbereich von ebenfalls ±25% hat, beträgt hier der Margin $M_{RCk}$ nur noch ≈ 30%, was aber immer noch zu groß ist.

Nach der Erfindung läßt sich nun entsprechend den Fig. 11a und 11b der jeweilige Toleranz-Teilbereich der Einschwingzeit der Operationsverstärker (Fig. 11a) und des On-Chip-RC-Oszillators (Fig. 11b) bis auf jeweils ±40% erhöhen, so daß der Margin $M_{Erf}$ nur noch ≈10% beträgt. Somit können dem Design der MOS-SC-Schaltung wesentlich verbesserte Randbedingungen zugrunde gelegt werden.

Obwohl anhand der Fig. 8 bis 11 die Verhältnisse bei Verwendung eines On-Chip-RC-Oszillators erläutert worden sind, gelten vergleichbare Überlegungen auch für den stromgesteuerten Taktoszillator entsprechend der Erfindung.

In Fällen, bei denen die Toleranz der Verlustleistung nicht unberücksichtigt bleiben kann, kann beim Design des Layouts der MOS-SC-Schaltung ein trimm- und somit einstellbarer Ruhestrom vorgesehen werden. Dann wird der Gesamtruhestrom vergrößert, wenn der den Ruhestrom bestimmende Widerstand vergrößert wird. Das kann z.B. dadurch realisiert werden, daß mehr und mehr CMOS-Transmission-Gates in Serie geschaltet werden oder daß z.B. der jeweilige Strom-Verstärkungsfaktor der Stromspiegel für den Ruhestrom vergrößert wird.

Der für eine einzelne MOS-SC-Schaltung erforderliche Einstellwert kann im Produktionsverlauf während deren Testens ermittelt und in einem Speicher, z.B. einem EEPROM o.ä., abgelegt werden.

Dieses Ruhestrom-Trimmen vergrößert den Margin $M_{Erf}$ nur nicht sehr wesentlich. Normalerweise genügt eine Trimmspanne von 25%, um eine annehmbare VersorgungsstromToleranz zu erreichen, da der Anstieg des Einschwingzeit-Fehlers der Schalter aufgrund dessen exponentieller Abhängigkeit nicht so groß ist. Somit ist bei der Erfindung der Einschwingzeit-Fehler von Versorgungsspannungs-, Temperatur- und Prozeßparameter-Änderungen weniger abhängig.

**Patentansprüche**

1. Monolithisch mittels Enhancement-Isolierschicht-Feldeffekt-Transistoren integrierte Switched-Capacitor-Schaltung

- mit mindestens einem Operationsverstärker (3),

-- der einen seinen Ruhestrom bestimmenden, als dauernd stromleitend betriebenen Transistor realisierten Widerstand enthält,

- mit einem On-Chip-Taktoszillator zur Abgabe eines Taktsignals,

-- der entweder ein RC-Taktoszillator ist, dessen Frequenz von einem als dauernd stromleitend betriebenen Transistor realisierten Oszillator-Widerstand ($W_o$ ; Figur 3) und einem Oszillator-Kondensator ($K_o$) bestimmt ist,
-- oder der ein stromgesteuerter Taktoszillator ist, dessen Frequenz vom Ruhestrom des Operationsverstärkers bestimmt ist,

- mit mindestens einem zwischen einem Signaleingang (E) und einem Signalausgang (A) liegenden Kondensator ($K_1$) und
- mit mindestens einem Schalter ($1_c$, $1_o$, $2_c$, $2_o$) in der Form eines Transistors, über den der Kondensator im Betrieb vom Operationsverstärker, getaktet vom Taktsignal, aufgeladen oder entladen wird.

2. MOS-SC-Schaltung nach Anspruch 1, bei der der dauernd stromleitende Transistor ein entsprechend beschaltetes CMOS-Transmission-Gate ist.

**Claims**

1. A switched-capacitor circuit which is monolithically integrated by means of enhancement-mode insulated-gate field-effect transistors

- having at least one operational amplifier (3),

-- which contains a resistor which determines its quiescent current and is realized as a transistor operated in the permanently current-conducting state,

- having an on-chip clock oscillator for generating a clock signal,

-- which is either an RC clock oscillator, whose frequency is determined by an oscillator resistor ($W_0$; figure 3), which is realized as a transistor operated in the permanently current-conducting state, and an oscillator capacitor ($K_0$),

-- or which is a current-controlled clock oscillator, whose frequency is determined by the quiescent current of the operational amplifier,

- having at least one capacitor ($K_1$) coupled between a signal input (E) and a signal output (A), and
- having at least one switch ($1_c$, $1_o$, $2_c$, $2_o$) in the form of a transistor, via which the capacitor is charged or discharged during operation by the operational amplifier, clocked by the clock signal.

2. A switched-capacitor circuit as claimed in claim 1 wherein the permanently current-conducting transistor is realized by a suitably biased CMOS transmission gate.

**Revendications**

1. Circuit à capacités commutées (SC) monolithique intégré avec transistors à effet de champ à couche isolante et à enrichissement, comprenant

- au moins un amplificateur opérationnel (3)

-- qui comprend une résistance déterminant son courant de repos, réalisée sous la forme d'un transistor à conduction de courant permanente,

- un oscillateur de synchronisation incorporé, pour fournir un signal de synchronisation, qui est

-- soit un oscillateur de synchronisation RC, dont la fréquence est déterminée par une résistance d'oscillateur ($W_o$; figure 3) réalisée sous la forme d'un transistor à conduction de courant permanente et par un condensateur d'oscillateur ($K_o$),
-- soit un oscillateur de synchronisation commandé par courant, dont la fréquence est déterminée par le courant de repos de l'amplificateur opérationnel,

- au moins un condensateur (K1) placé entre une entrée de signal (E) et une sortie de signal (A), et
- au moins un interrupteur ($1_c$, $1_o$, $2_c$, $2_o$) sous la forme d'un transistor par l'intermédiaire duquel le condensateur, pendant le fonctionnement de l'amplificateur opérationnel, est chargé ou déchargé, synchronisé par le signal de synchronisation.

2. Circuit (SC) selon la revendication 1, dit circuit MOS-SC, dans lequel le transistor à conduction de courant permanente est une grille de transmission CMOS branchée de façon appropriée.

# Fig.1a

# Fig.1b

# Fig.1c

# Fig.2

# Fig.3

Fig.4

Fig.5

Fig.6c

Fig.6a

Fig.6b

Fig.6d

Fig.6e

Fig.6f

Fig.7a

Fig.7b

Fig.7c

a)    −50%    +50%

b)    $M_Q \approx 55\%$

Fig.8

a)    −50%    +50%

b)    −30%    +30%

$M_{RC} \approx 80\%$

Fig.9

a)

b)

$M_{RCk} \approx 30\%$

Fig.10

a)

b)

$M_{Erf} \approx 10\%$

Fig.11